# EUROPEAN PATENT APPLICATION

(11) **EP 4 579 007 A1**
(43) Date of publication of application: **02.07.2025**
(21) Application number: 23856953.7
(22) Date of filing: 23.06.2023
(51) Int. Cl.: C30B 29/38, C30B 25/18, H01L 21/20, H01L 21/205

(54) **NITRIDE SEMICONDUCTOR SUBSTRATE AND METHOD FOR PRODUCING SAME**

(30) Priority: 22.08.2022 JP 2022132102
(71) Applicant: Shin-Etsu Handotai Co., Ltd., Tokyo 100-0004 (JP)
(72) Inventor: Kubono, Ippei, Annaka-shi, Gunma 379-0196 (JP); Hagimoto Kazunori, Annaka-shi, Gunma 379-0196 (JP)
(74) Representative: Sonnenhauser, Thomas Martin
(86) International application number: PCT/JP2023/023316
(87) International publication number: WO 2024/042836

(57) **Abstract**

The present invention is a nitride semiconductor substrate including, a silicon substrate having a resistivity of 1000 Ω·cm or higher or a base substrate including a silicon layer having a resistivity of 1000 Ω·cm or higher on a surface thereon, and a group III nitride semiconductor thin film epitaxially formed on the silicon substrate or the silicon layer, in which an average value of carbon concentration in the group III nitride semiconductor thin film is 3E+18 atoms/cm³ or less. This provides the nitride semiconductor substrate having low high-frequency loss and high thermal conductivity and a method for producing such a substrate.

## Description

### TECHNICAL FIELD

The present invention relates to a nitride semiconductor substrate and a method for producing the same.

### BACKGROUND ART

A group-III nitride semiconductor represented by GaN is expected to be the semiconductor material for the next generation, exceeding the limitation of Si (silicon) as the material. GaN has characteristics of high saturated electron velocity and thus can produce a device capable of high-frequency operation and operable at a higher output due to a large dielectric breakdown electric field. Moreover, weight reduction, miniaturization, and lower electric power consumption can be expected.

In recent years, the demand for an accelerated communication speed represented by 5G and an accompanying higher output has attracted attention toward a GaN HEMT operable at high frequency and high output. The GaN HEMT which is used for high-frequency devices is produced using mainly GaN epitaxial substrates obtained by forming GaN epitaxial thin films on base substrates by a MOCVD method or the like.

In some cases, semi-insulating SiC substrates having excellent thermal conductivity are used as the base substrate. On the other hand, due to the high costs of the semi-insulating SiC substrates, silicon substrates that can be produced at low costs may be adopted.

It is commonly known that when the silicon substrates are used as the base substrate for the GaN HEMT for high-frequency applications, it is necessary to make the substrate high resistance to reduce high-frequency loss due to parasitic capacity. Patent Documents 1 and 2 disclose resistivity of silicon substrates and carbon concentration in an epitaxial layer but have no disclosure regarding thermal conductivity. Patent Documents 3, 4, and 5 disclose carbon concentration in a GaN epitaxial layer and thermal conductivity, but resistivity and high-frequency characteristics of silicon substrates are not disclosed.

### CITATION LIST

### PATENT LITERATURE

Patent Document 1: JP 2010-245504 A
Patent Document 2: WO WO2011/016219 A1
Patent Document 3: JP 2008-179536 A
Patent Document 4: JP 2007-277077 A
Patent Document 5: JP 2009-269816 A

### SUMMARY OF INVENTION

### TECHNICAL PROBLEM

A nitride semiconductor substrate such as a GaN epitaxial substrate which is used for high-frequency application has a problem when heat dissipation properties of the substrate are poor (thermal conductivity is low), the substrate is unable to dissipate heat from a device, preventing long-term time use thereof. This also causes problems in which operating frequency and input power are unable to increase due to component degradation and temperature resistance problems.

In order to use a GaN epitaxial layer as a high-frequency device, while it is not possible to make a general rule thereof because such a rule depends on a specification and application of the device, a thermal conductivity of about 160 W/(m·K) or higher is preferable.

Furthermore, it is known that when a carbon concentration in GaN is high, dislocation density is increased, leading to deterioration of the thermal conductivity.

Moreover, it is also required that high-frequency loss caused by an increase in parasitic capacity is small. When the high-frequency loss is large, an increase in input power is required, which not only reduces the efficiency of the device but also increases the generated heat.

The present invention has been made to solve the above-described problem. An object of the present invention is to provide a nitride semiconductor substrate that has a low high-frequency loss and high thermal conductivity and a method for producing such a substrate.

### SOLUTION TO PROBLEM

To solve the above problem, the present invention provides a nitride semiconductor substrate comprising:
a silicon substrate having a resistivity of 1000 Ω·cm or higher or a base substrate including a silicon layer having a resistivity of 1000 Ω·cm or higher on a surface thereon; and
a group III nitride semiconductor thin film epitaxially formed on the silicon substrate or the silicon layer, wherein
an average value of carbon concentration in the group III nitride semiconductor thin film is 3E+18 atoms/cm³ or less.

In this way, when the silicon substrate has a resistivity of 1000 Ω·cm or higher, or the base substrate includes the silicon layer having a resistivity of 1000 Ω·cm or higher on the surface thereon, it is possible to prevent an increase in parasitic capacity, thereby suppressing high-frequency loss. When the average value of carbon concentration in the group III nitride semiconductor thin film is 3E+18 atoms/cm³ or less, dislocation density is decreased, and thus thermal conductivity can be increased. As a result, the nitride semiconductor substrate having low high-frequency loss and high thermal conductivity can be provided.

Moreover, it is preferable that the base substrate comprises a composite substrate having a plurality of layers being laminated, with the silicon layer laminated thereon via a planarization layer, and
the composite substrate comprises:
   a support structure including a polycrystalline ceramic core, a first adhesive layer laminated entirely to the polycrystalline ceramic core, and a barrier layer laminated entirely to the first adhesive layer;
   a second adhesive layer laminated to a back surface of the support structure; and
   a conductive layer laminated to a further back surface of the second adhesive layer,
the planarization layer is laminated to a front surface of the support structure of the composite substrate, and
the silicon layer is laminated on the planarization layer.
such a base substrate can provide the nitride semiconductor substrate having low high-frequency loss and high thermal conductivity relatively easily.

In addition, the group III nitride semiconductor thin film preferably contains any one or more of GaN, AlN, and AlGaN.

Such a group III nitride semiconductor thin film can provide the nitride semiconductor substrate having low high-frequency loss and high thermal conductivity relatively easily.

Moreover, the group III nitride semiconductor thin film preferably has a thickness of 1.0 µm or more and 5 µm or less.

In the present invention, the group III nitride semiconductor thin film can have such a film thickness.

Moreover, the present invention provides a method for producing a nitride semiconductor substrate, the method comprising the steps of:
(1) providing a silicon substrate having a resistivity of 1000 Ω·cm or higher or a base substrate including a silicon layer having a resistivity of 1000 Ω·cm or higher on a surface thereon; and
(2) epitaxially forming a group III nitride semiconductor thin film on the silicon substrate or the silicon layer, wherein
the group III nitride semiconductor thin film is epitaxially formed to have an average value of carbon concentration of 3E+18 atoms/cm³ or less.

In this way, when the production method for epitaxial forming, in which the silicon substrate having a resistivity of 1000 Ω·cm or higher or the base substrate including the silicon layer having a resistivity of 1000 Ω·cm or higher on the surface is used, makes the average value of carbon concentration in the group III nitride semiconductor thin film 3E+18 atoms/cm³ or less, it becomes relatively easier to produce the nitride semiconductor substrate having low high-frequency loss and high thermal conductivity.

Moreover, it is preferred that
in the step of (2),
a forming temperature is adjusted to make the average value of carbon concentration in the group III nitride semiconductor thin film 3E+18 atoms/cm³ or less.

When the forming temperature is adjusted in this way, the carbon concentration in the group III nitride semiconductor thin film can be adjusted relatively easily and can produce the nitride semiconductor substrate having low high-frequency loss and high thermal conductivity.

Moreover, it is preferred that
in the step (1),
the base substrate comprises a composite substrate having a plurality of layers being laminated, with the silicon layer laminated thereon via a planarization layer, and
the composite substrate comprises:
   a support structure including a polycrystalline ceramic core, a first adhesive layer laminated entirely to the polycrystalline ceramic core, and a barrier layer laminated entirely to the first adhesive layer;
   a second adhesive layer laminated to a back surface of the support structure; and
   a conductive layer laminated to a further back surface of the second adhesive layer,
the planarization layer is laminated to a front surface of the support structure of the composite substrate, and
the silicon layer is laminated on the planarization layer.
such a base substrate can produce the nitride semiconductor substrate having low high-frequency loss and high thermal conductivity relatively easily.

Moreover, the group III nitride semiconductor thin film epitaxially formed on the silicon substrate or the silicon layer preferably contains any one or more of GaN, AlN, and AlGaN.

Such a group III nitride semiconductor thin film can produce the nitride semiconductor substrate having low high-frequency loss and high thermal conductivity relatively easily.

Moreover, the group III nitride semiconductor thin film preferably has a thickness of 1.0 µm or more and 5 µm or less.

In the present invention, the group III nitride semiconductor thin film can be produced such that the film has such a thickness.

### ADVANTAGEOUS EFFECTS OF INVENTION

As described above, according to the present invention, the nitride semiconductor substrate having low high-frequency loss and high thermal conductivity and a method for producing such a substrate can be provided, when the silicon substrate or the silicon layer of the base substrate including the silicon layer on the surface has a resistivity of 1000 Ω·cm or higher, and the group III nitride semiconductor thin film epitaxially formed on the silicon substrate or the silicon layer has an average value of carbon concentration being 3E+18 atoms/cm³ or less.

When the high-frequency loss is reduced, efficiency of a device is improved, allowing for a reduction of input power and resulting in effects such as a reduced amount of generated heat.

As the thermal conductivity increases, the heat dissipation of the substrate improves, resulting in dissipating heat easier from the device. This enables a longer-time use and has a possibility for improved durability and temperature resistance of components. Furthermore, it is possible to enhance operating frequency or input power.

### BRIEF DESCRIPTION OF DRAWINGS

FIG. 1 is a schematic view illustrating an example of a nitride semiconductor substrate according to the present invention.
FIG. 2 is a schematic view illustrating an example of a base substrate used for a nitride semiconductor substrate according to the present invention.
FIG. 3 is a graph showing thermal conductivities of group III nitride semiconductor thin films of nitride semiconductor substrates produced in Examples and Comparative Examples.
FIG. 4 is a graph showing second harmonic characteristics of nitride semiconductor substrates produced in Examples and Comparative Examples.
FIG. 5 is a graph showing surface temperatures of devices of nitride semiconductor substrates produced in Examples and Comparative Examples.

### DESCRIPTION OF EMBODIMENTS

As described above, developments of the nitride semiconductor substrate having low high-frequency loss and high thermal conductivity and a method for producing such a substrate have been required.

To solve the above problem, the present inventors have earnestly studied and found out that, by adjusting both a resistivity of a silicon substrate or a silicon layer of a base substrate including the silicon layer on a surface, and a carbon concentration in a group III nitride semiconductor thin film which is epitaxially formed on the silicon substrate or the silicon layer, in a predetermined range, a nitride semiconductor substrate having low high-frequency loss and high thermal conductivity can be produced. Based on this finding, the present invention has been completed.

That is, the present invention is a nitride semiconductor substrate comprising:
a silicon substrate having a resistivity of 1000 Ω·cm or higher or a base substrate including a silicon layer having a resistivity of 1000 Ω·cm or higher on a surface thereon; and
a group III nitride semiconductor thin film epitaxially formed on the silicon substrate or the silicon layer, wherein
an average value of carbon concentration in the group III nitride semiconductor thin film is 3E+18 atoms/cm³ or less.

Moreover, the present invention is a method for producing a nitride semiconductor substrate, the method comprising the steps of:
(1) providing a silicon substrate having a resistivity of 1000 Ω·cm or higher or a base substrate including a silicon layer having a resistivity of 1000 Ω·cm or higher on a surface thereon; and
(2) epitaxially forming a group III nitride semiconductor thin film on the silicon substrate or the silicon layer, wherein
the group III nitride semiconductor thin film is epitaxially formed to have an average value of carbon concentration of 3E+18 atoms/cm³ or less.

Hereinafter, the present invention will be described in detail. However, the present invention is not limited thereto.

### [Nitride Semiconductor Substrate]

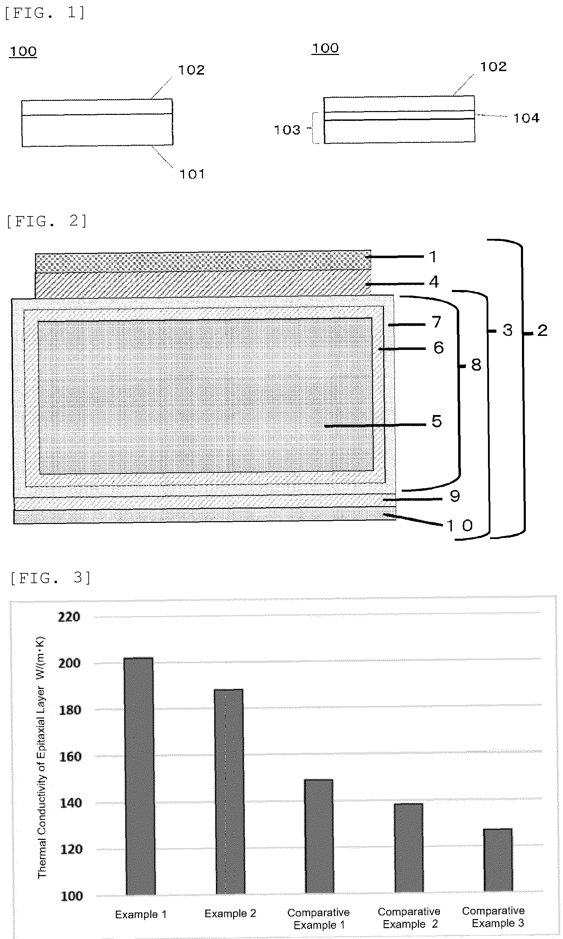

Here, FIG. 1 shows an example of the inventive nitride semiconductor substrate. A left figure in FIG. 1 shows an example using a silicon substrate, and a right figure in FIG. 1 shows an example of laminating a silicon layer on a surface of a base substrate. In the left figure in FIG. 1, a nitride semiconductor substrate 100 is configured to epitaxially form a group III nitride semiconductor thin film 102 on a silicon substrate 101 having a resistivity of 1000 Ω·cm or higher and is epitaxially formed to make an average value of a carbon concentration in the group III nitride semiconductor thin film 102 3E+18 atoms/cm³ or less. In the right figure in FIG. 1, the nitride semiconductor substrate 100 is configured to laminate a silicon layer 104 having a resistivity of 1000 Ω·cm or higher on a surface of a base substrate 103 and to epitaxially form the group III nitride semiconductor thin film 102 on the silicon layer 104, and to epitaxially form thereof so as to make the average value of the carbon concentration in the group III nitride semiconductor thin film 102 3E+18 atoms/cm³ or less.

In this way, when the silicon substrate has a resistivity of 1000 Ω·cm or higher, or the base substrate includes the silicon layer having a resistivity of 1000 Ω·cm or higher on a surface thereon, it is possible to prevent an increase in parasitic capacity, thereby suppressing high-frequency loss. When the average value of carbon concentration in the group III nitride semiconductor thin film is 3E+18 atoms/cm³ or less, dislocation density is decreased, and thus thermal conductivity can be increased. As a result, the nitride semiconductor substrate having low high-frequency loss and high thermal conductivity can be provided.

When the high-frequency loss is reduced, efficiency of a device is improved, allowing for a reduction of input power and resulting in effects such as a reduced amount of generated heat.

As the thermal conductivity increases, the heat dissipation of the substrate improves, resulting in dissipating heat easier from the device. This enables a longer usable time and has a possibility for improved durability and temperature resistance of components. Furthermore, improvement in operating frequency or input power can be achieved.

The upper limit of the resistivity is not particularly limited but can be, for example, 8000 Q.cm or less.

The lower limit of the average value of the carbon concentration is not particularly limited but can be, for example, 1E+15 atoms/cm³ or higher.

### Silicon Substrate or Base Substrate

As described above, a substrate for epitaxially growing the group III nitride semiconductor thin film may be the silicon substrate or the base substrate including the silicon layer on the surface. For example, the substrate may be the silicon substrate having a crystal orientation of <111>, and the substrate having a diameter of 150 mmφ and a thickness of 675 µm may be selected. The crystal orientation is required to be <111> but an off angle of a few degrees is not problematic. Moreover, the diameter and the substrate thickness are not limited thereto.

Alternatively, when the substrate is provided with the silicon layer having the crystal orientation of <111> on the surface, it is not problematic that the whole substrate is not a single piece of silicon but a bonded substrate having a layered structure.

Moreover, the resistivity of the silicon substrate or the silicon layer on the surface can be adjusted to 1000 Ω·cm or higher. A dopant element at this time is not limited, and therefore a conductivity type is not limited.

Furthermore, the thickness of the substrate is not particularly limited, but a thickness specified in SEMI standard (675 µm for 6-inch (150 mm) substrate, 725 µm for 8-inch (200 mm) substrate, and 775 µm for 12-inch (300 mm)) may be used. Alternatively, substrates having thicknesses such as 1 mm, 1.15 mm, 1.5 mm may also be used.

### (Base Substrate)

As shown in FIG. 2, a base substrate 2 for epitaxial forming includes, for example, a composite substrate 3 having a plurality of layers being laminated, with a silicon layer 1 laminated thereon via a planarization layer 4, and
the composite substrate 3 includes: a support structure 8 including a polycrystalline ceramic core 5, a first adhesive layer 6 laminated entirely to the polycrystalline ceramic core 5, and a barrier layer 7 laminated entirely to the first adhesive layer 6; a second adhesive layer 9 laminated to a back surface of the support structure 8; and a conductive layer 10 laminated to a further back surface of the second adhesive layer 9, the planarization layer 4 is laminated to a front surface of the support structure 8 of the composite substrate 3, and the silicon layer 1 is laminated on the planarization layer 4.
such a base substrate 2 can provide the nitride semiconductor substrate having low high-frequency loss and high thermal conductivity relatively easily.

Here, the polycrystalline ceramic core 5 is, for example, a sintered body of aluminum nitride, and sintered at a high temperature of approximately 1800°C using a sintering aid.

The first adhesive layer 6 and the second adhesive layer 9 are, for example, silicon oxide (SiO₂) layers, deposited by an LPCVD process. The thickness thereof can be approximately 100 nm.

The barrier layer 7 can be, for example, a silicon nitride layer, deposited by the LPCVD process or the like, having a thickness of approximately 250 nm.

The conductive layer 10 can be, for example, a polysilicon layer, deposited by the LPCVD process, having a thickness of approximately 300 nm.

The planarization layer 4 can contain, for example, tetraethyl orthosilicate (TEOS) or silicon oxide (SiO₂), deposited by the LPCVD process or the like, having a thickness of approximately 2000 nm.

The silicon layer 1 is a layer having, for example, a crystal orientation of <111> and a thickness of approximately 350 nm. This silicon layer 1 can be produced using a so-called ion implantation separation technique including, for example, a step of ion implanting to the silicon substrate, a step of bonding to the planarization layer 4, and a step of separating by leaving the predetermined silicon layer 1 after heat treatment. By using the silicon substrate having a resistivity of 1000 Ω·cm or higher here, the silicon layer 1 on the surface after bonding can have a resistivity of 1000 Ω·cm or higher.

### Group III Nitride Semiconductor Thin Film

The group III nitride semiconductor thin film is formed on the above silicon substrate or the silicon layer of the base substrate.

For example, the group III nitride semiconductor thin film such as AlN, AlGaN, and GaN is epitaxially grown on a composite substrate for growth in a MOCVD reaction furnace to produce the nitride semiconductor substrate. A layer structure of an epitaxial layer is not particularly limited and is adjusted to suit an application of the device. A case where AlGaN is not formed and a case where AlGaN is formed followed by a formation of AlN are included. In some cases, a plurality of layers of AlGaN with varying Al composition are formed.

Here, the carbon concentration in the group III nitride semiconductor is set to 3E+18 atoms/cm³ or less based on an average value when the thicknesses in an entire area are measured in 10 to 15 nm steps. This reduces dislocation density of the epitaxial layer and improves the thermal conductivity of the epitaxial layer.

This group III nitride semiconductor thin film is required to have a certain thickness (generally 1.5 µm or more, although this varies depending on a device application) to play a role as a base layer that is essential to make a device layer stacked on the thin film high-quality. On the other hand, the thickness is preferably about 1.0 µm to 5 µm because a too-thick film causes high cost given raw material consumption, film-forming time, and the like. Because of having such a certain thickness, the heat-dissipating property of this layer significantly affects the entire heat-dissipating property of the substrate. In a high-frequency device, the device layer itself often has a thickness of a few nm to a few hundred nm, consequently, even when only the device layer has low carbon, sufficient heat dissipation cannot be obtained.

### Device Layer

A front surface side of the above nitride semiconductor substrate can be provided with a device layer. For example, in the case of HEMT, the device layer can have a structure provided with a highly crystalline layer where two-dimensional electron gas is generated (channel layer), a layer for generating two-dimensional electron gas (barrier layer), and a cap layer on the topmost surface layer. The AlGaN having the Al composition of about 20% can be used for the barrier layer, but InGaN, for example, can also be used, and not limited thereto. The cap layer can be, for example, the GaN layer or the SiN layer but not limited thereto. In addition, the thicknesses of these device layers and the Al composition of the barrier layer are changed depending on the design of the device. Moreover, when the substrate is intended for use as a template substrate used for producing bulk GaN by an HVPE method or the like, it is also possible not to provide the device layer.

### [Method for Producing Nitride Semiconductor Substrate]

The inventive nitride semiconductor substrate described above can be produced as follows. Hereinafter, the inventive method for producing a nitride semiconductor substrate will be described.

### <Step (1)> Providing Silicon Substrate or Base Substrate

The step (1) is a step of providing a silicon substrate having a resistivity of 1000 Ω·cm or higher or a base substrate including a silicon layer having a resistivity of 1000 Ω·cm or higher on a surface thereon. The silicon substrate or the base substrate provided may be the substrates described earlier.

### <Step (2)> Epitaxially Forming

The step (2) includes a step of epitaxially forming a group III nitride semiconductor thin film on the silicon substrate or the silicon layer, and this is a step of epitaxially forming to make an average value of carbon concentration in the group III nitride semiconductor thin film 3E+18 atoms/cm³ or less.

The group III nitride semiconductor thin film such as GaN, AlN, and AlGaN is epitaxially grown on a silicon layer 1 of a base substrate 2 described above, in a MOCVD reaction furnace. As raw materials, TMGa (trimethyl gallium) can be used as a Ga source, TMAL (trimethyl aluminum) as an Al source, and NH₃ (ammonia) as an N source. A carrier gas can be N₂, H₂, or either of them and the forming temperature is about 900 to 1250°C, for instance.

For example, the forming temperature is adjusted to make the average value of carbon concentration in the group III nitride semiconductor thin film 3E+18 atoms/cm³ or less. An amount of carbon incorporated from MO raw materials varies depending on the forming temperature, the carbon concentration can be easily adjusted at a low cost. By adjusting the forming temperature, the average value of carbon concentration in the group III nitride semiconductor thin film can be adjusted to 3E+18 atoms/cm³ or less. As a result, dislocation density can be lowered, enabling the production of the nitride semiconductor substrate having high thermal conductivity.

Note that the device layer may be formed on the front surface side of the nitride semiconductor substrate.

In the above, the amount of carbon incorporated from MO raw materials being varied depending on the forming temperature is used to make the average value of carbon concentration in the entire group III nitride semiconductor thin film 3E+18 atoms/cm³ or less. While adopting this because the carbon concentration can be easily adjusted at a low cost but an adjustment method for the carbon concentration is not limited thereto. It is needless to say the adjustment by external doping and other methods are sufficient.

As described above, when the production method for epitaxial forming, in which the silicon substrate having a resistivity of 1000 Ω·cm or higher or the base substrate including the silicon layer having a resistivity of 1000 Ω·cm or higher on the surface is used, makes the average value of carbon concentration in the group III nitride semiconductor thin film 3E+18 atoms/cm³ or less, it becomes relatively easier to produce the nitride semiconductor substrate having low high-frequency loss and high thermal conductivity.

### EXAMPLES

Hereinafter, the present invention will be specifically described with reference to Examples and Comparative Examples. However, the present invention is not limited thereto.

### (Examples 1 to 3)

Nitride semiconductor substrates in Examples 1 to 3 were produced, varying resistivities of silicon layers on surfaces of base substrates and carbon concentrations in group III nitride semiconductor thin films, as shown in Tables 1 and 2, in the following procedures.

### (Providing Base Substrate)

A base substrate for epitaxial forming was provided in the following steps.

In this case, instead of a silicon substrate, a bonded substrate with a silicon surface layer was used.

This bonded substrate was provided with a support structure 8 including a polycrystalline ceramic core 5, a first adhesive layer 6 bonded entirely to the polycrystalline ceramic core 5, and a barrier layer 7 bonded entirely to the first adhesive layer 6; a second adhesive layer 9 bonded only to a back surface side of the support structure 8; a conductive layer 10 bonded to a further back surface side of the second adhesive layer 9, a planarization layer 4 bonded only to a front surface side of the barrier layer 7, and a silicon layer 1 bonded to the planarization layer 4 (FIG. 2).

Here, the polycrystalline ceramic core 5 was a sintered body of aluminum nitride and was sintered at a high temperature of approximately 1800°C using a sintering aid.

The first adhesive layer 6 and the second adhesive layer 9 were silicon oxide (SiO₂) layers, deposited by an LPCVD process. The thicknesses thereof were approximately 100 nm.

The barrier layer 7 was a silicon nitride layer, deposited by the LPCVD process or the like, having a thickness of approximately 250 nm.

The conductive layer 10 was a polysilicon layer, deposited by the LPCVD process, having a thickness of approximately 300 nm.

The planarization layer 4 was SiO₂, deposited by the LPCVD process or the like, having a thickness of approximately 2000 nm.

The silicon layer 1 had a crystal orientation of <111> and a thickness of approximately 350 nm. This silicon layer 1 was produced using a so-called ion implantation separation technique including a step of ion implanting to the silicon substrate, a step of bonding to the planarization layer 4, and a step of separating by leaving the predetermined silicon layer after heat treatment. By using a silicon substrate having a resistivity of 1000 Ω·cm or higher, the silicon layer on the surface after bonding had a resistivity of 1000 Ω·cm or higher. Tables 1 and 2 show actual resistivities.

**[Table 1]**

| | Si Layer Resistivity | Epitaxial Layer carbon concentration | GaN Layer Film Forming Temperature |
|---|---|---|---|
| | (Ω·cm) | (atoms/cm³) | (°C) |
| Example 1 | 1040 | 9.60E+17 | 1080 |
| Example 2 | | 2.91E+18 | 1037 |
| Comparative Example 1 | | 5.04E+18 | 1025 |
| Comparative Example 2 | | 9.22E+18 | 1009 |
| Comparative Example 3 | | 1.33E+19 | 998 |

**[Table 2]**

| | Si Layer Resistivity | Epitaxial Layer carbon concentration | GaN Layer Film Forming Temperature |
|---|---|---|---|
| | (Ω·cm) | (atoms/cm³) | (°C) |
| Comparative Example 4 | 10 | 2.91E+18 | 1037 |
| Comparative Example 5 | 612 | | |
| Comparative Example 6 | 825 | | |
| Example 2 | 1040 | | |
| Example 3 | 4300 | | |

### (Epitaxially Forming Group III Nitride Semiconductor Thin Film)

With the above as the base substrate, the group III nitride semiconductor thin film such as AlN, AlGaN, and GaN was epitaxially grown on the silicon layer in a MOCVD reaction furnace. As raw materials, TMG (trimethyl gallium) was used as a Ga source, TMA (trimethyl aluminum) as an Al source, and ammonia as an N source. N₂ and H₂ were used as a carrier gas.

A design of the epitaxial layer, in this case, involves an AlN layer of 150 nm provided directly above the base substrate, followed by an AlGaN layer of 250 nm thereon, a GaN layer formed further on the top and a total thickness of the epitaxial layer was designed to be approximately 2 µm. A forming temperature was adjusted to make an average value of carbon concentration in the entire epitaxial layer at this time 3E+18 atoms/cm³ or less. Tables 1 and 2 show the forming temperature of the GaN layers at this time. This approach was adopted because the amount of carbon incorporated from MO raw materials varies depending on the forming temperature, allowing for inexpensive and easy adjustment of the carbon concentration. In addition, measurements of the carbon concentrations in the epitaxial layers were performed by SIMS. The carbon concentration measurements by SIMS were measured in 15 to 20 nm steps, and the average values were calculated at all points where the carbon concentrations of the GaN layers were measured, excluding the portions where the carbon concentrations of the surface layers were unable to be measured correctly.

### (Measurement of High-Frequency Loss)

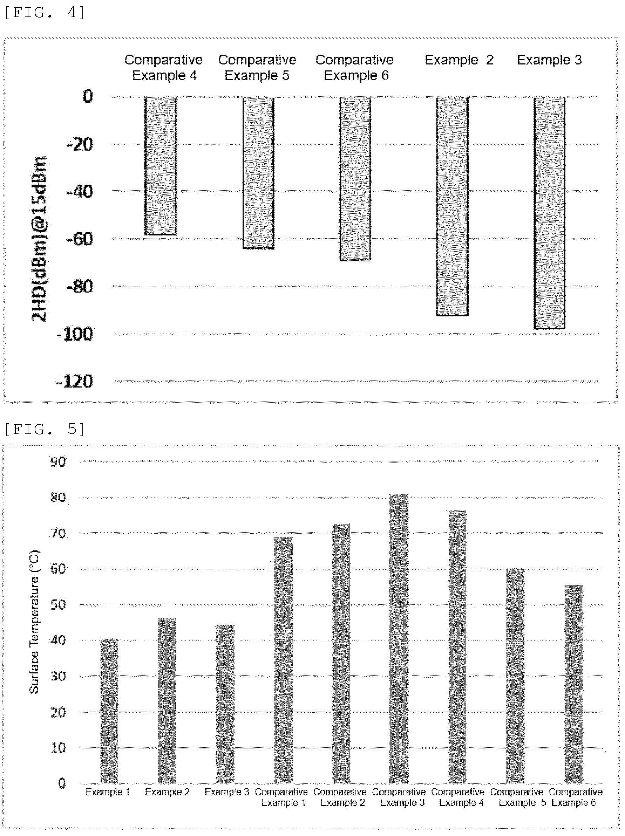

In the nitride semiconductor substrate produced as described above, electrodes were formed and then measurements of high-frequency loss were performed. This is a method for forming an electrode referred to as a coplanar waveguide on a group III nitride thin film, inputting a high-frequency signal having a constant frequency from an IN side of the electrode, and measuring the intensity of a high-frequency signal outputted from an OUT side of the electrode. The high-frequency signal ideally propagates 100% only in the electrode but a part of the signal passes through the substrate, and outputs from the OUT side. The signal that passes through the substrate is detected as a harmonic component; this method measures an amount of loss to the substrate side by measuring the intensity of this harmonic component. Consequently, the smaller the intensity of the harmonic signal (the larger the absolute value, as it is a negative value), the more component is transmitted within the electrode, indicating an ideal substrate. FIG. 4 shows the results.

### (Measurement of Thermal Conductivity)

In addition, thermal conductivities of GaN epitaxial layers were measured by a thermo-reflectance method. FIG. 3 shows the results.

### (Comparative Examples 1 to 6)

As shown in Tables 1 and 2, nitride semiconductor substrates were produced using the same base substrate and group III nitride semiconductor thin film as in Example 1 except that resistivities of silicon layers on surfaces of base substrates and/or average carbon concentrations of group III nitride semiconductor thin film were varied as shown in Tables.

As in Examples 1 to 3, electrodes were formed on the nitride semiconductor substrate and high-frequency losses were measured, and thermal conductivities of GaN epitaxial layers were also measured by the thermo-reflectance method. FIGs. 3 and 4 show the results.

In addition, in configurations of the group III nitride semiconductor thin films in Examples and Comparative Examples, GaN layers accounted for the majority of the total thickness and were layers that determined thermal conductivity characteristics of the substrates. Therefore, it was considered sufficient to ascertain the carbon concentrations of the GaN layers, and the results of forming temperatures and carbon concentrations for GaN layers alone were shown in Tables 1 and 2.

In Comparative Examples 1, 2, and 3, although the silicon layers had resistivities of 1000 Ω·cm or higher, the substrates had low thermal conductivities due to high carbon concentrations in the epitaxial layers (FIG. 3). Although input power is not needed to increase because of small high-frequency loss, generated heat cannot be dissipated sufficiently, potentially causing device malfunctions.

In Comparative Examples 4, 5, and 6, the resistivities of the silicon layers were low, resulting in the substrates having a large high-frequency loss (FIG. 4). When compared with Examples, more power was required. Even with high thermal conductivities of the epitaxial layers, the device cannot dissipate heat sufficiently, and it operates at a high temperature, which resulting in device malfunctions.

In Examples, since all problems were solved, it was indicated that the devices were operable at high frequency and high input power.

### (Measuring Surface Temperature of Device)

High-frequency devices were produced, using the substrates from Examples 1, 2, and 3 and Comparative Examples 1 to 6. These devices were operated at drain-to-source voltage V_{DS}=28 V and input frequency at f=3.5 GHz and the surface temperatures of the devices after 20 minutes of operation were investigated. FIG. 5 shows the results.

Even when either the carbon concentrations of the epitaxial layers or the resistivities of the silicon layers were satisfied as shown in Comparative Examples, it was confirmed that temperature rose due to heat generated by the device, which may potentially cause malfunction.

Moreover, the type and proportion of molecules generated from the decomposition of raw materials vary depending on a growth temperature. Therefore, an optimal temperature range exists for high-quality and efficient crystal growth. In a case of the GaN epitaxial layer, a temperature of approximately 900 to 1250°C is appropriate, and the GaN epitaxial layer does not grow properly at unnecessarily high temperatures.

Furthermore, when an extremely low-carbon GaN epitaxial layer is obtained using other methods, it may be acceptable to use a silicon layer having a resistivity of less than 1000 Ωcm solely from the perspective of heat dissipation. However, a state where harmonic components are large (signal leakage to the substrate) persists, and thus such characteristics are unacceptable from the perspective of overall device characteristics.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A nitride semiconductor substrate comprising:
a silicon substrate having a resistivity of 1000 Ω·cm or higher or a base substrate including a silicon layer having a resistivity of 1000 Ω·cm or higher on a surface thereon; and
a group III nitride semiconductor thin film epitaxially formed on the silicon substrate or the silicon layer, wherein
an average value of carbon concentration in the group III nitride semiconductor thin film is 3E+18 atoms/cm³ or less.

2. The nitride semiconductor substrate according to claim 1, wherein
the base substrate comprises a composite substrate having a plurality of layers being laminated, with the silicon layer laminated thereon via a planarization layer, and
the composite substrate comprises:
a support structure including a polycrystalline ceramic core, a first adhesive layer laminated entirely to the polycrystalline ceramic core, and a barrier layer laminated entirely to the first adhesive layer;
a second adhesive layer laminated to a back surface of the support structure; and
a conductive layer laminated to a further back surface of the second adhesive layer,
the planarization layer is laminated to a front surface of the support structure of the composite substrate, and
the silicon layer is laminated on the planarization layer.

3. The nitride semiconductor substrate according to claim 1, wherein
the group III nitride semiconductor thin film contains any one or more of GaN, AlN, and AlGaN.

4. The nitride semiconductor substrate according to claim 2, wherein
the group III nitride semiconductor thin film contains any one or more of GaN, AlN, and AlGaN.

5. The nitride semiconductor substrate according to any one of claims 1 to 4, wherein
the group III nitride semiconductor thin film has a thickness of 1.0 µm or more and 5 µm or less.

6. A method for producing a nitride semiconductor substrate, the method comprising the steps of:
(1) providing a silicon substrate having a resistivity of 1000 Ω·cm or higher or a base substrate including a silicon layer having a resistivity of 1000 Ω·cm or higher on a surface thereon; and
(2) epitaxially forming a group III nitride semiconductor thin film on the silicon substrate or the silicon layer, wherein
the group III nitride semiconductor thin film is epitaxially formed to have an average value of carbon concentration of 3E+18 atoms/cm³ or less.

7. The method for producing a nitride semiconductor substrate according to claim 6, wherein
in the step of (2),
a forming temperature is adjusted to make the average value of carbon concentration in the group III nitride semiconductor thin film 3E+18 atoms/cm³ or less.

8. The method for producing a nitride semiconductor substrate according to claim 6, wherein
in the step (1),
the base substrate comprises a composite substrate having a plurality of layers being laminated, with the silicon layer laminated thereon via a planarization layer, and
the composite substrate comprises:
a support structure including a polycrystalline ceramic core, a first adhesive layer laminated entirely to the polycrystalline ceramic core, and a barrier layer laminated entirely to the first adhesive layer;
a second adhesive layer laminated to a back surface of the support structure; and
a conductive layer laminated to a further back surface of the second adhesive layer,
the planarization layer is laminated to a front surface of the support structure of the composite substrate, and
the silicon layer is laminated on the planarization layer.

9. The method for producing a nitride semiconductor substrate according to claim 7, wherein
in the step (1),
the base substrate comprises a composite substrate having a plurality of layers being laminated, with the silicon layer laminated thereon via a planarization layer, and
the composite substrate comprises:
a support structure including a polycrystalline ceramic core, a first adhesive layer laminated entirely to the polycrystalline ceramic core, and a barrier layer laminated entirely to the first adhesive layer;
a second adhesive layer laminated to a back surface of the support structure; and
a conductive layer laminated to a further back surface of the second adhesive layer,
the planarization layer is laminated to a front surface of the support structure of the composite substrate, and
the silicon layer is laminated on the planarization layer.

10. The method for producing a nitride semiconductor substrate according to claim 6, wherein
the group III nitride semiconductor thin film epitaxially formed on the silicon substrate or the silicon layer contains any one or more of GaN, AlN, and AlGaN.

11. The method for producing a nitride semiconductor substrate according to claim 7, wherein
the group III nitride semiconductor thin film epitaxially formed on the silicon substrate or the silicon layer contains any one or more of GaN, AlN, and AlGaN.

12. The method for producing a nitride semiconductor substrate according to claim 8, wherein
the group III nitride semiconductor thin film epitaxially formed on the silicon substrate or the silicon layer contains any one or more of GaN, AlN, and AlGaN.

13. The method for producing a nitride semiconductor substrate according to claim 9, wherein
the group III nitride semiconductor thin film epitaxially formed on the silicon substrate or the silicon layer contains any one or more of GaN, AlN, and AlGaN.

14. The method for producing a nitride semiconductor substrate according to any one of claims 6 to 13, wherein
the group III nitride semiconductor thin film has a thickness of 1.0 µm or more and 5 µm or less.
